# EUROPEAN PATENT APPLICATION

(11) **EP 0 651 258 A2**
(43) Date of publication of application: **03.05.1995**
(21) Application number: 94308045.7
(22) Date of filing: 01.11.1994
(51) Int. Cl.: G01R 15/18, G01R 19/20

(54) **DC current sensor**

(30) Priority: 02.11.1993 JP 297542/93
(71) Applicant: SUMITOMO SPECIAL METAL CO., LTD., Osaka City, Osaka (JP)
(72) Inventor: Kawakami, Makoto, Suita-shi, Osaka (JP)
(74) Representative: Livsey, Gilbert Charlesworth Norris

(57) **Abstract**

It is an object of the present invention to provide a sensitive DC current sensor, which has a relatively simple construction and a detecting capability with a good linearity, against current variations in a wide range from a microscopic current to a relatively large current (e.g. about 0.2 A to 20 A). In the configuration, wherein an exciting coil and a detecting coil are wound in a toroidal shape around a core consisting of an annular soft magnetic material, when a triangular waveform exciting current which produces a magnetic field exceeding a coercive force of the core is applied to the exciting coil, a direction of the magnetic flux in the core is inverted, whereby an absolute value and a direction of a DC current flowing through a lead wire being detected can be detected, by detecting an inverse timing by a pulse voltage produced in the detection coil for comparison measurement of the pulse intervals.

## Description

### BACKGROUND OF THE INVENTION

### Field of the Invention

The present invention relates to a DC current sensor, which is used in a wide field such as a current instrumentation in maintenance of a switch-board control circuit signal, detection of analog current signals from various sensors installed in large-sized equipments in a steel mill and the like, and the current instrumentation for controlling small-sized DC equipments, particularly, it relates to a sensitive DC current sensor having a relatively simple construction and a detecting capability with a good linearily, against variations in a wide range from a microscopic current to a relatively large current (e.g. about 0.2 A to 20 A).

### Description of the Prior Art

In recent years, equipments using a DC current sensor are increasing in many technical fields, and for operating these equipments safely and smoothly, DC current instrumentation is inevitable and the sensitive DC current sensor is badly needed. As such DC current sensor, a hall device method, a magnetic amplifier method and magnetic multi-vibrator method are known (Japanese Patent Application Laid Open Nos. Sho 47-1644, Sho 53-31176, Sho 59-46859).

The hall device method is constituted such that, a lead wire being detected is directly wound around a core made of a soft magnetic material, in which a hall device is disposed partly and a gap portion is formed, in a toroidal shape, whereby a magnetic flux variation in the core according to the variation of DC current flowing through the lead wire being detected is detected directly by the hall device.

The magnetic amplifier method and magnetic multivibrator method are that, a core made of soft magnetic material, around which a detecting coil is wound in a toroidal shape, is used, the lead wire being detected is disposed through the core, and by DC magnetic deflection of the core made of soft magnetic material within a saturated magnetic flux density (Bs) by the DC current flowing through the lead wire being detected, imbalance is produced at a time, where an alternating magneticflux produced by applying an AC current to the coil wound around the core beforehand reaches saturation, in the positive and negative directions, and the variation is detected by the detecting coil.

In the magnetic amplifier method, since the magnetic flux variation is produced in the core beforehand, it is constituted such that, an exciting coil is wound around the core to apply determined AC current therethrough, but in the magnetic multi-vibrator method, it is constituted such that, self-oscillation is produced by the operation of semiconductors and the like in a circuit connected to the detecting coil, and a duty ratio of the oscillation waveform is changed for oscillation responsive to an electric current being detected.

Though the hall device method has a relatively simple construction and is easy to handle, since its detecting capability is inevitably decided by characteristics of the hall device, when the present known hall device is used, it is difficult to measure the electric current of 20 A or less at a relatively high accuracy (about ± 2%) thus it is, usually, limited for use in a large detecting current (i. e. above 20 A).

For example, though it is possible to use the hall device to amplify the detecting signal by an amplifier, an offset output caused by a coercive force of the core constituting the DC current sensor, and a drift caused by temperature characteristics of the hall device are large, thus it is necessary to adjust a zero point always to realize the required high measurement accuracy, results in a low particularly.

Also, though it may be considered to wind the lead wire being detected around the core constituting the DC current sensor by several hundreds to several thousands turns or more, the DC current sensor becomes larger and its use is large restricted.

Meanwhile, though it is possible to measure a relatively small electric current by the magnetic amplifier method and magnetic multi-vibrator method as compared with the hall device method, the construction becomes complicated and as previously described, a DC magnetic deflection is required so as to saturate the core made of soft magnetic material substantially near to the saturated magnetic flux density (Bs), by the DC current flowing through the lead wire being detected, thus the lead wire being detected must be wound around the core by several tens to several hundreds turns or more responsive to the detecting current, thus its use is largely limited.

Furthermore, since magnetic characteristic peculiar to the core itself appears in the output characteristics as it is, the linearity is poor and the required high measurement accuracy can not be realized.

As described heretofore, it is hard to say that, the conventionally known hall device method, magnetic amplifier method and magnetic multi-vibrator method are constituted to cope with the current variations in a wide range from a small current to relatively large current (e.g. about 0.2 A to 20 A), and at present, they are not practically used as the sensitive DC current sensor.

### SUMMARY OF THE INVENTION

It is an object of the present invention to provide a sensitive DC current sensor, which solves the aforementioned problems, and has a relatively simple construction and a detecting capability with a good linearity, against current variations in a wide range from a microscopic current to a relatively large current (e.g. about 0.2 A to 20 A).

As the result of various studies made on means for achieving the above-mentioned objects, in the most simple configuration where an exciting coil and a detecting coil are wound, in a toroidal shape around a core consisting of an annular soft magnetic material, viewing the fact that, a direction of a magnetic flux in the core is inverted at the time of applying a triangular waveform exciting current which produces magnetic field exceeding a coercive force a coercive force of the core, to the exciting coil, the inventors have found that, an absolute value of a DC current flowing through a lead wire being detected can be detected, by detecting the inverse timing by a pulse voltage produced in the detecting coil for comparative measurement of the pulse intervals.

The present invention is directed to a DC current sensor, which has been developed according to the above-mentioned learning, comprising: a core consisting of an annular soft magnetic material, wherein a lead wire being detected, through which a DC current flows for non-contact detection, is extended though; an exciting coil and a detecting coil wound around the core in a toroidal shape; whereby a triangular waveform exciting current which produces magnetic field exceeding a coercive force of the core in the core is applied to the exciting coil, and the inverse timing of a direction of the magnetic flux in the core is detected by the pulse voltage produced in the detecting coil for comparison measurement of the pulse intervals, thereby an absolute value of a DC current flowing through the lead wire being detected is detected.

The DC current sensor of the present invention has a relatively simple construction, because it adopts, as a basic configuration, the most simple configuration, wherein the exciting coil and the detecting col are wound in a toroidal shape around the core consisting of the annular soft material. Also, since it is constituted to detect the absolute value and a direction of the DC current flowing through the lead wire being detected, by applying the triangular waveform exciting current which produces the magnetic field exceeding the coercive force of the core, to the exciting core, and detecting the inverse timing of the direction of the magnetic flux in the core at that time by the pulse voltage produced in the detecting coil for comparison measurement of the pulse intervals, an electric circuit is not too complicated and a detecting capability with good linearity is obtained, against a wide range of current variations from a microscopic current to a relative large current (e. g. about 0.2 A to 20 A), thus it can be adopted as a sensor for use in control and maintenance of various DC equipments.

Particularly, by adopting the configuration wherein the core can be divided, at least, at one portion in a circumferential direction, it is very simple to mount to the wired lead being detected, thus the DC current sensor can be used more widely.

### BRIEF DESCRIPTION OF THE DRAWINGS

Fig. 1 is a schematic explanatory view showing one embodiment of a DC current sensor of the present invention.
Figs. 2(A to D) are explanatory views showing an outline of electrical signals at locations A to D in electric circuits shown in Fig. 1.
Figs. 3(A to E) are conceptional explanatory views showing a principle of operation of the DC current sensor shown in Fig. 1.
Fig. 4(A) is an explanatory plan view showing another embodiment of a DC current sensor of the present invention, and (B) shows an explanatory front view thereof.
Fig. 5 is a linear graph showing the relationship between DC current flowing through a lead wire being detected and an output in the DC current sensorof the present invention shown in Fig. 1.
Fig. 6 is a linear graph showing the relationship between a DC current flowing through a lead wire being detected and an output in the DC current sensor of the present invention shown in Fig. 1.

### DETAILED DESCRIPTION OF THE PREFERRED EMBODIMENTS

In the following, the operation of a DC current sensor of the present invention is particularly described based on the drawings.

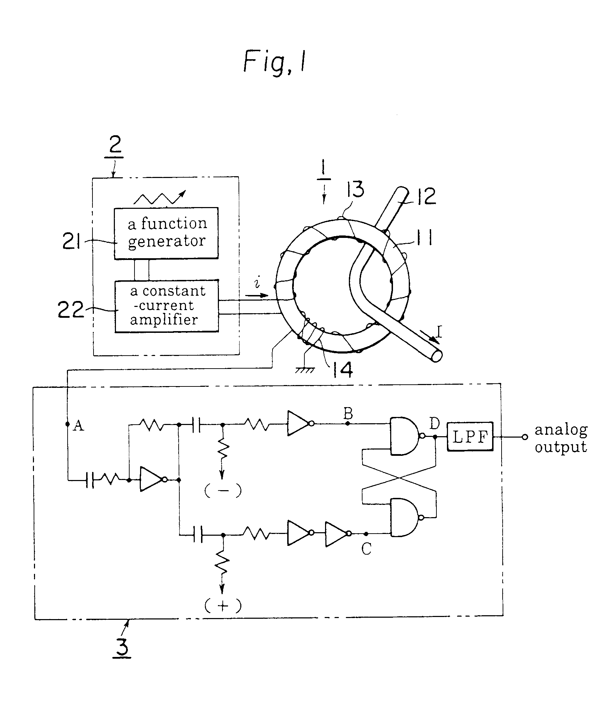

Fig. 1 is a schematic explanatory view showing one embodiment of a DC current sensor of the present invention, wherein numeral 1 designates a main body of the DC current sensor.

In Fig. 1, numeral 11 designates a core consisting of an annular soft magnetic material, wherein a lead wire being detected 12, through which a DC current flows for non-contact detection, is extended through. The core 11 is formed by, punching the soft magnetic material composed of a known permalloy and the like into a ring shape, and after predetermined heat treatment, laminating a plurality of sheets and disposing inside an insulation resin case.

In Fig. 1, numeral 13 designates an exciting coil, which is wound in a toroidal shape around the core 11. Numeral 14 designates a detecting coil, which is wound in a toroidal shape around the core 11 as same as the exciting coil 13.

In Fig. 1, numeral 2 designates a power source portion connected to the exciting coil 13. The power source 2 comprises a function generator 21 and a constant-current amplifier 22, and applies a predetermined triangular waveform exciting current to be described later. Numeral 3 designates an electric circuit portion connected to the detecting coil 14, whereby a predetermined analog output is obtained responsive to a pulse voltage detected by the detecting coil 14 to be described later.

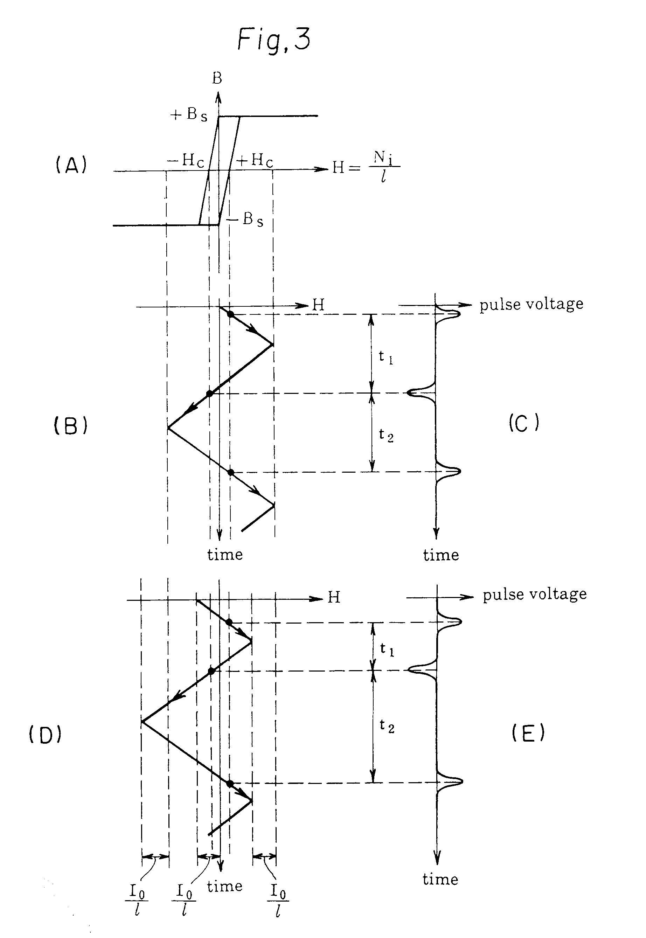

In this configuration, when magnetic characteristics of the core 11 is as shown in Fig. 3(A), a triangular waveform exciting current i, which produces a magnetic field exceeding a coercive force of the core 11, is applied to the exciting coil 13. That is, when a current peak value is ip and the coercive force of the core 11 is Hc, the peak value ip of the triangular waveform exciting current is set so as to obtain Hc « Niₚ/I.

Where, N represents the number of turns of the exciting coil 3, and represents a magnetic path length of the core 11. The time variation of a magnetic field H in the exciting core 11 by the exciting current i is shown in Fig. 3(B).

In the case where the electric current is not flowing through the lead wire being detected 12, or in the case of I = 0, when the exciting current i increases and Ni/I = Hc is established, or the exciting current i reduces and Ni/l= -Hc is established, the direction of magnetic flux in the core 11 is inverted rapidly, and an inverse pulse voltage as shown in Fig. 3(C) is produced in the detecting coil 14 at inversion.

Hereupon, when the coercive force (Hc) of the core 11 is symmetrical positively and negatively, regardless of the intensity of the coercive force (Hc), pulse intervals t₁, t₂ produced at the crest and trough of the triangular wave are equal (referto Fig. 3(B) and Fig. 3(C)).

In the case where the current I is flowing through the lead wire being detected 12 (I = 1₀), since the magnetic field (l₀/I is produced beforehand by the current I flowing through the lead wire being detected 12, besides the magnetic field produced by increment and decrement of the exciting current i as described above in the core 11, when the magnetic fields are superposed and, as shown in Fig. 3(D), the exciting current i is incremented such that the magnetic field H in the exciting core 22 satisfies H = Ni// - loll = + Hc, or when the exciting current i is decreased such that magnetic field H in the exciting core 11 satisfies H = Ni/I-I₀/I=-Hc, the direction of the magnetic flux in the core 11 is inverted rapidly, and an inverse pulse voltage as shown in Fig. 13(E) is produced in the detecting coil 14 at inversion.

In this case, even when the coercive force (Hc) of the core 11 is symmetrical positively and negatively, a difference (t₁ < t₂) is produced in the pulse intervals t₁, t₂ produced at the crest and trough of the triangular wave (referto Fig. 3(D) and Fig. 3(E)). However, when variation of the exciting current I per time is constant, and the absolute values of inclination at increment and decrement are same

(di (increment)/dt = -di (decrement)/dt = constant), the electric current I flowing through the lead wire 12 being detected is proportional to {(t₂ - t₁)/(t₂ + t₁)}.

Thus, by measuring the correlation between the difference of pulse intervals t₁, t₂ and the electric current I flowing through the lead wire being detected 12 beforehand, the absolute value and the direction of the electric current I flowing through the lead wire being detected 12 can be detected, by electrically measuring the pulse intervals t₁, t₂.

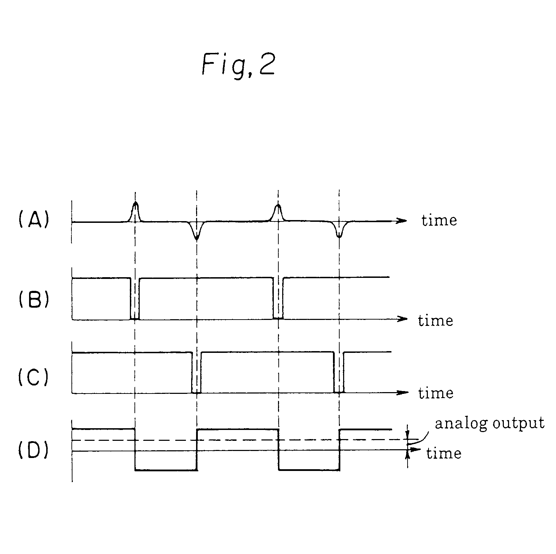

For example, in the configuration shown in Fig. 1, when a predetermined triangular waveform exciting current i is applied the exciting coil 13 from the power source portion 2 consisting of the function generator and the constant-current amplifier, and the electric current I is flowing through the lead wire being detected 12, a pulse voltage corresponding to the absolute value of the electric current I is detected in the detecting coil 14 and finally a predetermined analog output can be obtained via the electric circuit 3. Fig. 2 shows the outline of electric signals at respective locations A to D in the electric circuit 3 shown in Fig. 1.

Though the configuration, wherein the exciting coil 13 and the detecting coil 14 are wound around the core 11 independently, has been described above, since the exciting coil 13 and the detecting coil 14 are substantially wound in the same direction at the same location, and the aforementioned pulse voltage is also produced in the exciting coil 13, it is possible to use a function of the detecting coil 14 in common by the exciting coil 13 itself, by adding a circuit which takes out only the pulse component electrically.

The DC current sensor of the present invention can be divided easily, because the construction of the core 11 is very simple. Thus, it is very easy to mount to the exciting lead wire being detected, largely expanding its use.

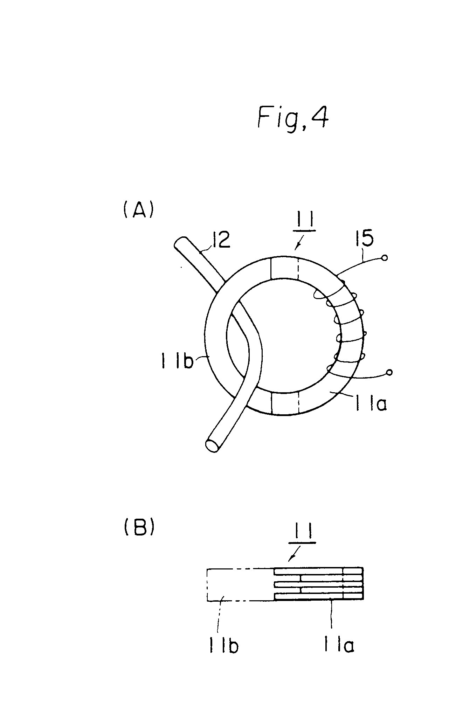

Figs.4(A), (B) are respectively an explanatory plan view and an explanatory front view showing one embodiment of a DC current sensor of the present invention adopting a split-type core.

Acore 11 is constituted by a pair of core members 11a a and 11b forming substantially a C shape. A common coil 15, in which functions of an exciting coil and a detecting coil are used commonly, is wound only around one core member (11a side in the figure). Connection of the pair of core members 11a and 11 b may be constituted to form depressions and protrusions so as to be engaged smoothly one another in a body, by adjusting the amount of core productions at the opposing portions, as shown in the figure, beforehand.

Thus, for disposing the wired lead being detected 12 through the core 11 of the DC current sensor of the present invention, it can be easily accomplished by engaging the opposing portions in a body, after disposing the pair of core members 11a a and 11 b around the lead wire being detected 12 without cutting it. Also, since the common coil 15 is disposed only on one core member, and further, even when the exciting coil and the detecting coil are disposed independently, a required measurement can be realized by disposing on one core member, and the possibility of cutting the coil when connecting and integrating the pair of core members 11a and 11 b is reduced, results in easy handling.

Furthermore, the DC current sensor of the present invention is characterized in that, the measurement accuracy can be maintained even when adopting the split-type core. That is, not a little magnetic gap is produced in the construction where the split-type core is assembled. For example, in the C-shaped clamp type configuration (a damp type tester), which can be operated by a single hand, in an electromagnetic conversion type using a hall device (a method of detecting a magnetic flux density ora a magnetic flux amount), since the magnetic flux density produced in the core is reduced by the magnetic gap of a core contact portion, which is closed by means of a spring and the like, after disposing the lead wire being detected in the C-shaped core, thereby a measurement error is produced, though it is necessary to clamp the core contact portion by means of a screw and the like to reduce magnetic resistance, the screwing method can to be adopted in the handy type, and the magnetic resistance changes by variations of a pressing force of the core contact portions, thus the stable measurement value can not be obtained.

However, in the present invention, even when the split-type core is adopted, though the magnetic resistance increases at the contact and connecting portion of the core members, since the height of the pulse signal produced in the detecting coil only reduces, and positions by time or the inverse timing does not change at all, the detecting accuracy is influenced very little by dividing the core, and for example, by connecting an electric circuit which detects the pulse peak positions, the same measurement as the case of adopting the non-split-type core previously described can be realized, therefore, it is most suitable for use in the handy clamp type as described above.

The DC current sensor of the present invention described above is that, though an annular soft magnetic material is indispensable as the core, it is desirable to select the soft magnetic material responsive to an intensity of the electric current flowing through the lead wire being detected, or the detecting sensitivity, and the like required for the sensor. Usually, though permalloy is preferable when considering magnetic characteristics as well as the workability, the other known soft magnetic materials such as a silicon steel plate, amorphous, electromagnetic soft iron and soft ferrite may be used independently or in combination.

Likewise, though these soft magnetic materials may be constituted by a single plate, they may also be constituted by laminating a plurality of soft magnetic material sheets in a body as the embodiment previously described.

Furthermore, in the DC current sensor of the present invention, with respect to the annular soft magnetic material, it is not limited to a so-called ring shape, the soft magnetic material may be just connected so as to constitute a closed electromagnetic circuit, and various configurations such as an oval ring shape, a rectangular frame shape and the like besides an annular shape, as shown, may be adopted.

Particularly, in the case of using the split-type core, it is preferable to select the number of splits and configuration of the connection, considering the location where the lead wire being detected is disposed, and the workability of assembling and integration of the core members, without being restricted to the configuration of the embodiment previously described.

When necessary, the DC current sensor of the present invention is desirably covered by a shield case consisting of a permalloy or anisotropic silicon steel plate to prevent induction noises from mixing in.

### EXAMPLE

A thin plate of 0.5 mm thick consisting of permalloy C (78% Ni - 5% Mo -4% Cu - baFe) was punched into a ring shape of 45 mm outside diameter and 33 mm inside diameter. The ring was heated in a hydrogen gas atmosphere at 1100°C for 3 hours, and further, subjected to multi-stage cold treatment between 600°C and 400°C at 100°C/hr, to prepare a core material constituting a DC current sensor of the present invention.

Three sheets of core materials were laminated and disposed inside a case composed of insulation resin to obtain an annular core 11.

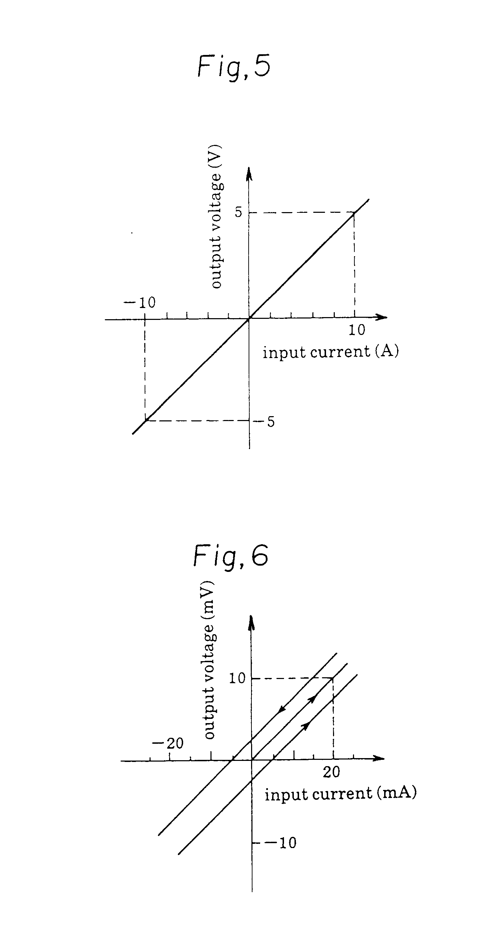

An exciting coil 13 was prepared by winding a formal wire of 0.2 mm outside diameter in a toroidal shape around the core 11 by 100 turns. A detecting coil 14 was prepared by winding a formal wire of 0.1 mm outside diameter in a toroidal shape by 100 turns. The exciting coil 13 and the detecting coil 14 were respectively connected to a power source portion 2 and an electric circuit portion 3 as shown in Fig. 1 to complete the DC current sensor of the present invention. Fig. 5 shows final output characteristics at the time of, after disposing a lead wire being detected 12 of 8 mm outside diameter consisting of a vinyl coating through the core 11, applying a triangular waveform current of 50 Hz, ip=±0.15A to the exciting coil 13, and changing a DC current (current being detected) applied to the lead wire being detected 12.

Fig. 6 shows output characteristics, particularly, at a microscopic current region.

As it is apparent from the embodiment, a precise measurement is possible against current variations in a relatively wide range (an accuracy of ± 2% was secured in the range of 0.5 A to 10 A), and also a relatively precise measurement is similarly possible in the microscopic current region (an accuracy of ± 5% was secured in the range of 0.1 A to 0.5 A), thus it can be adopted in various uses, particularly, the effect of the present invention can be effectively realized in control and maintenance of DC equipments.

## Claims

1. A DC current sensor comprising: a core consisting of an annular soft magnetic material, wherein a lead wire being detected, through which a DC current flows for non-contact detection, is extended through; an exciting coil and a detecting coil wound around said core in a toroidal shape; whereby a triangular waveform exciting current which produces a magnetic field exceeding a coercive force of the core in said core is applied to said exciting coil, and an inverse timing of a direction of a magnetic flux in the core is detected by a pulse voltage produced in said detecting coil for comparison measurement of said pulse intervals, thereby an absolute value of the DC current flowing through the lead wire being detected is detected.

2. A DC current sensor in accordance with claim 1, wherein functions of an exciting coil and a detecting coil are commonly used by one coil.

3. A DC current sensor in accordance with claim 1, wherein a core can be divided, at least, at one portion in a circumferential direction when disposing a lead wire being detected therethrough.

4. A DC current sensor in accordance with claim 1, wherein a core consisting of an annular soft magnetic material is constituted by laminating a plurality of soft magnetic material sheets in a body.

5. A DC current sensor in accordance with claim 1, wherein a core consisting of an annular soft magnetic material is composed of permalloy.
